# EUROPEAN PATENT SPECIFICATION

(11) **EP 0 810 663 B1**
(45) Date of publication and mention of the grant of the patent: **03.08.2005**
(21) Application number: 97108643.4
(22) Date of filing: 28.05.1997
(51) Int. Cl.: H01L 27/08

(54) **Layout structure of capacitive elements and interconnections in a semiconductor**
Layout-Struktur kapazitiver Elemente und deren Verbindungsleitungen auf einem Halbleiter
Structure d'arrangement d'éléments capacitifs et interconnexions dans un semi-conducteur

(30) Priority: 30.05.1996 JP 15901996
(43) Date of publication of application: 03.12.1997
(73) Proprietor: Tokyo Electron Limited, Tokyo 107-8481 (JP)
(72) Inventor: Hirota, Yoshihiro, Sakyo-ku, Kyoto, 606 (JP); Matsumoto, Toshiyuki, Sanda, Hyogo-ken, 669-13 (JP); Shou, Guoliang, Setagaya-ku, Tokyo 155 (JP); Motohashi, Kazunori, Setagaya-ku, Tokyo 155 (JP)
(74) Representative: Grünecker, Kinkeldey, Stockmair & Schwanhäusser Anwaltssozietät

(56) References cited:
- US-A- 4 929 998
- US-A- 5 322 438
- MCNUTT M J ET AL: "SYSTEMATIC CAPACITANCE MATCHING ERRORS AND CORRECTIVE LAYOUT PROCEDURES" IEEE JOURNAL OF SOLID-STATE CIRCUITS, vol. 29, no. 5, 1 May 1994, pages 611-616, XP000466042

## Description

### FIELD OF THE INVENTION

The present invention relates to a layout structure of interconnections and capacitive elements of a semiconductor.

### BACKGROUND OF THE INVENTION

In FIG. 6, a capacitive element in a semiconductor consists of a plurality of unit electrodes (not shown) in capacitive element area CDA and a common electrode (not shown) facing the area through an insulation film (not shown). The unit capacitor electrodes are arranged two-dimensionally to form one, or a plurality of, capacitive element(s) with predetermined capacity. FIG. 6 shows capacitive element CD formed as above. Each unit electrode is linked to main interconnections L1 and L2, and the common electrodes are linked to main interconnection L3 through sub-interconnections OL for the common electrode. These interconnections generally lead in the direction of the capacitive element, and their intervals are the design rule minimum to reduce interconnection space to realize a compact semiconductor.

However, in such an interconnection layout structure, parasitic capacities are generated between L3 and, L1 or L2. They cause lower accuracy in calculations depending on the accuracy of the capacitive element(s). Especially when a plurality of capacitive elements is arrayed as above, the parasitic capacity value differs for every capacitive element, because the parasitic capacity between L1 and L3 and that between L2 and L3 are not generally equal. Consequently, it is the cause of output errors. US-A-4 929 998 discloses a capacitive element layout.

### SUMMARY OF THE INVENTION

The present invention solves the above conventional problems and has an object to provide an interconneciton layout structure for reducing the effects of the parasitic capacity of interconnection in the capacitive elements.

In a capacitive element layout structure and interconnection layout of a semiconductor according to the present invention, sub-interconnections for unit capacitor electrodes and those for the common electrode are set in different directions. Accordingly, the main interconnections linked to these lines have enough distance to control the parasitic capacity.

### BRIEF DESCRIPTION OF THE DRAWINGS

FIG. 1 shows a ground plan of an embodiment of the capacitive element and interconnection layout structure used in the present invention.
FIG. 2 shows a ground plan of the details in FIG. 1.
FIG. 3 shows an equivalent circuit of the capacitive element and interconnection layout structure in FIG. 1.
FIG. 4 shows a circuit applying the present embodiment.
FIG. 5 is a graph comparing the capacitive element and interconnection layout structures of the present invention and the conventional one.
FIG. 6 shows a capacitive element CD.

### PREFERRED EMBODIMENT OF THE PRESENT INVENTION

Hereinafter an embodiment of a capacitive element layout structure and interconnection layout structure of a semiconductor according to the present invention is described with reference to the attached drawings.

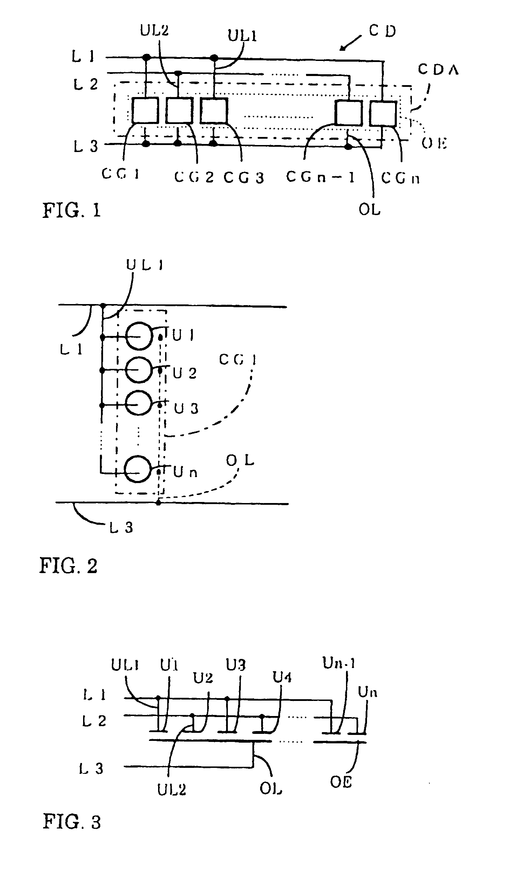

In FIGS. 1 and 2, capacitive element CD is structured in capacitive element area CDA by parallelly arranging unit capacitor electrode groups CG1 to CGn, in which a plurality of unit capacitor electrodes U1 to Un are set in straight array. The unit capacitor electrodes are formed in regular shapes such as squares, circles octagons, et al. Each unit capacitor electrode is connected to unit capacitor electrode sub-interconnection UL1 or UL2, which are linked to main interconnections L1 and L2, respectively. In capacitive element area CDA, a common electrode OE is formed to this whole area, and between this common electrode and said unit electrodes, an insulation film (not shown) is formed. To common electrode OE, sub-interconnection OL for a plurality of common electrodes is connected, and OE is connected to L3 through OL.

In FIG. 2, only CG1 is shown. U1 to Un in CG1 are connected to L1 and L3 through UL1 and OL, respectively. CG2 to CGn are structured similar to CG1, so that the even-numbered unit capacitor electrode groups, such as CG2, are connected to L2 and L3 through UL2 and OL, respectively, and the odd-numbered ones are connected to L1 and L3 through UL1 and OL, respectively.

FIG. 3 shows an equivalent circuit of capacitive element CD. As shown, common electrode OE is a common opposite electrode of all the unit capacitor electrodes, connected to L3 by sub-interconnection OL. However, in an actual semiconductor, unit electrodes and the common electrode are polysilicon and all have an inner resistance. Setting each capacity accurately as a counterpart of each unit capacitor electrode, as shown in FIG. 2, means connecting the common electrodes and OL at all positions virtually corresponding to each unit capacitor electrode. As the common electrode and the unit capacitor electrodes are formed in different layers, OE and OL are shown by broken lines in FIGS. 1 and 2, respectively. Main interconnections L1 to L3 are formed in a layer different from that where UL1, UL2 and OL are formed, and UL1, UL2 and OL are therefore led to the layer of L1 to L3 through a via hole (not shown).

As is clear from FIG. 3, sub-interconnections UL1, UL2 and OL are set in the direction of the arrangement of unit capacitor electrodes in each unit capacitor electrode group, and OL is led to the opposite direction of L1 and L2. Consequently, L1 and L2 are alienated enough from L3 to decrease the generation of parasitic capacities between both L1 and L3, and between L2 and L3 to the extent that no problem is encountered in actual use.

With the structure above, the capacitance value set by capacitive element CD is more accurate than the conventional one. Although two capacitance values are shown in the present embodiment, the number is not limited to two.

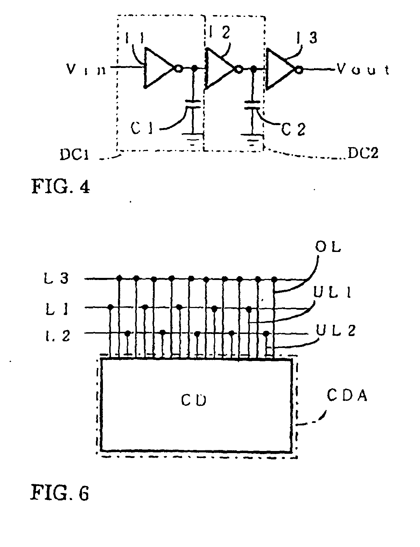

FIG. 4 is a circuit in which such an accurate capacitance is requisite. It includes delay circuit DC1 having capacity C1 and inverter I1, delay circuit DC2 having capacity C2 and inverter I2, and inverter 13. In this embodiment, the delay values of DC1 and DC2 are accurately obtained by setting the capacity values of C1 and C2.

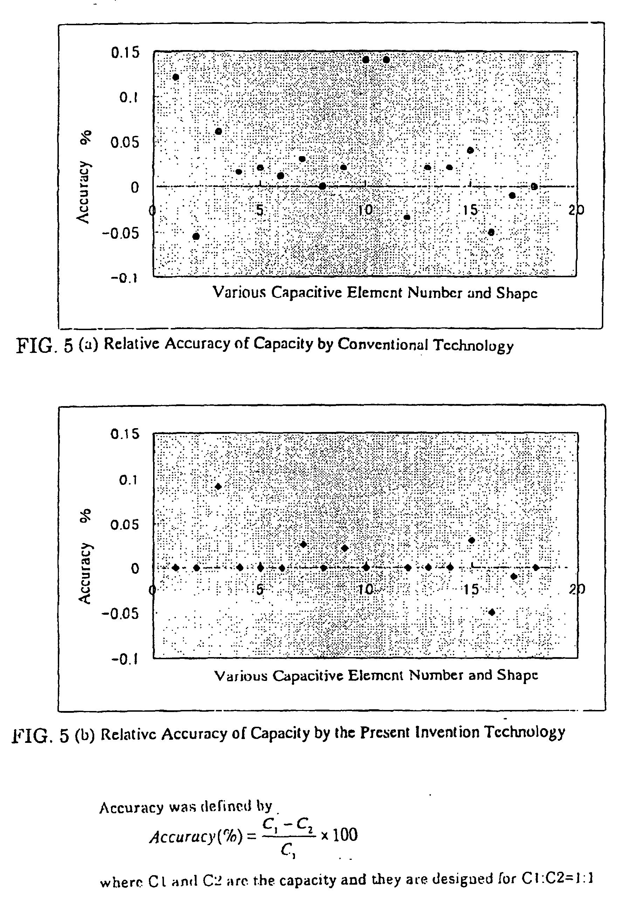

FIG. 5 compares the accuracy of various capacitive elements of this invention with conventional ones. Accuracy is shown with respect to 18 kinds of elements each having a different number of capacitive elements, a different shape, and a different size. FIG. 5(a) shows the accuracy where two sub-interconnections from each capacitive element and the sub-interconnections from common electrode are set in the same direction the capacitive element, and the sub-interconnections are independently connected to main interconnection via hole. FIG. 5 (b) shows the accuracy where conditions are similar to FIG. 5(a), except the two unit capacitor electrode sub-interconnections and the common electrode sub-interconnection are set in the opposite direction from the capacitive element. Table 1 shows capacitive element details.

**TABLE 1**

| Main Interconnection | |
|---|---|
| Line Width | 1.2 µm |
| Space | 1.0 µm |

| Sub-Interconnection | |
|---|---|
| Line Width | 1.0 µm |
| Space | 1.0 µm |

| Conditions of Electrode Formation | |
|---|---|
| Unit Electrode Shape | Circle, Square |
| Unit Electrode Size | Side or diameter is 5 µm, 10 µm, and 20 µm |
| Unit Capacitor Number | 16, 32 and 64 |
| Unit Electrode Distribution Space | 5 to 6 µm |
| Electrode Thickness | 400nm |
| Insulator Thickness | 16nm |
| Electrode Material | P⁺ doped Polysilicon |
| Via Hole Diameter | 1.2 µm |

As is clear from FIG. 5, the present invention lowers the parasitic capacity of the capacitive element improving relative accuracy and proving a excellent precision semiconductor LSI circuit using a capacity. The unit capacitor electrode need not be only round or square: can be octagonal or of various other shapes.

As mentioned above, in a capacitive element layout structure and interconnection layout structure of a semiconductor according to the present invention, a unit capacitor electrode sub-interconnections and a common electrode sub-interconnection are set in different directions so that the main interconnections linked to them have enough distance to control parasitic capacity. Therefore, capacitive element accuracy can be improved.

## Claims

1. A capacitive element layout structure of a semiconductor device comprising:
a first layer having a capacitive element area (CDA) with a plurality of parallel electrode groups (CG1 to CGn) wherein each electrode group includes a plurality of unit electrodes (U1 to Un) arranged in a straight array;
a second layer having a common electrode (OE) that covers the whole capacitive element area (CDA) wherein said common electrode (OE) is arranged to face all said unit electrodes (U1 to Un);
an insulating layer between said first and said second layers;
a plurality of first conductor lines (L1, L2) outside said capacitive element area (CDA) in the direction said unit electrode groups are arranged;
a second conductor line (L3) outside said capacitive element area (CDA) in the direction said unit electrode groups are arranged and being opposite from said first conductor lines (L1, L2) with reference to said capacitive element area (CDA);
a plurality of first lead lines (UL1, UL2) for connecting said unit electrodes (U1 to Un) of said electrode groups (CG1 to CGn) with corresponding ones of said first conductor lines (L1, L2), respectively; and
a plurality of second lead lines (OL) for connecting said common electrode (OE) with said second conductor line (L3) at positions corresponding to said unit electrodes (U1 to Un);
whereby one or more capacitive elements (CD) are formed, and said first (UL1, UL2) and second (OL) lead lines run in opposite directions toward said first (L1, L2) and second (L3) conductor lines, respectively.

2. A capacitive element layout structure of a semiconductor device as claimed in claim 1, wherein said first (L1, L2) and second (L3) conductor lines run in a direction substantially perpendicular to said parallel electrode groups (CG1 to CGn).

3. A capacitive element layout structure of a semiconductor device as claimed in claim 1 or 2, wherein said first (UL1, UL2) and second (OL) lead lines are substantially perpendicular to said conductor lines (L1, L2, L3).

## Patentansprüche

1. Layout-Struktur des kapazitiven Elementes einer Halbleitervorrichtung, die umfasst:
eine erste Schicht, die einen Bereich eines kapazitiven Elementes (CDA) mit einer Vielzahl paralleler Elektrodengruppen (CG1 bis CGn) aufweist, wobei jede Elektrodengruppe eine Vielzahl von Einzelelektroden (U1 bis Un) enthält, die in einer geraden Gruppierung angeordnet sind;
eine zweite Schicht, die eine gemeinsame Elektrode (OE) aufweist, die den gesamten Bereich des kapazitiven Elementes (CDA) abdeckt, wobei die gemeinsame Elektrode (OE) so angeordnet ist, dass sie allen Einzelelektroden (U1 bis Un) zugewandt ist;
eine isolierende Schicht zwischen der ersten und der zweiten Schicht;
eine Vielzahl erster Leiterbahnen (L1, L2) außerhalb des Bereiches des kapazitiven Elementes (CDA) in der Richtung, in der die Einzelelektrodengruppen angeordnet sind;
eine zweite Leiterbahn (L3) außerhalb des Bereiches des kapazitiven Elementes (CDA) in der Richtung, in der die Einzelelektrodengruppen angeordnet sind, die den ersten Leiterbahnen (L1, L2) in Bezug auf den Bereich des kapazitiven Elementes (CDA) gegenüberliegt;
eine Vielzahl erster Zuleitungen (UL1, UL2), die die Einzelelektroden (U1 bis Un) der Elektrodengruppen (CG1 bis CGn) jeweils mit entsprechenden der ersten Leiterbahnen (L1,L2) verbinden; und
eine Vielzahl zweiter Zuleitungen (OL), die die gemeinsame Elektrode (OE) mit der zweiten Leiterbahn (L3) an Positionen verbinden, die den Einzelelektroden (U1 bis Un) entsprechen;
wobei ein oder mehrere kapazitive Element/e (CD) ausgebildet ist/sind und die ersten (UL1, UL2) sowie zweiten (OL) Zuleitungen in entgegengesetzten Richtungen auf die ersten (L1, L2) Leiterbahnen bzw. die zweite (L3) Leiterbahn zu verlaufen.

2. Layout-Struktur des kapazitiven Elementes einer Halbleitervorrichtung nach Anspruch 1, wobei die ersten (L1, L2) Leiterbahnen und die zweite (L3) Leiterbahn in einer Richtung im Wesentlichen senkrecht zu den parallelen Elektrodengruppen (CG1 bis CGn) verlaufen.

3. Layout-Struktur des kapazitiven Elementes einer Halbleitervorrichtungen nach Anspruch 1 oder 2, wobei die ersten (UL1, UL2) und die zweiten (OL) Zuleitungen im Wesentlichen senkrecht zu den Leiterbahnen (L1, L2, L3) sind.

## Revendications

1. Structure d'arrangement d'éléments capacitifs d'un dispositif semi-conducteur comprenant :
une première couche ayant une zone d'élément capacitif (CDA) avec une pluralité de groupes d'électrodes parallèles (CG1 à CGn) dans lesquels chaque groupe d'électrodes comprend une pluralité d'électrodes unitaires (U1 à Un) agencées en un alignement rectiligne ;
une seconde couche ayant une électrode commune (OE) qui couvre l'ensemble de la zone d'élément capacitif (CDA), dans laquelle ladite électrode commune (OE) est agencée de manière à être en face de toutes lesdites électrodes unitaires (U1 à Un) ;
une couche d'isolation entre ladite première et ladite seconde couche ;
une pluralité de premières lignes conductrices (L1, L2) en dehors de ladite zone d'élément capacitif (CDA) dans la direction dans laquelle lesdits groupes d'électrodes unitaires sont agencés ;
une seconde ligne conductrice (L3) en dehors de ladite zone d'élément capacitif (CDA) dans la direction dans laquelle lesdits groupes d'électrodes unitaires sont agencés, et à l'opposé desdites premières lignes conductrices (L1, L2) par rapport à ladite zone d'élément capacitif (CDA) ;
une pluralité de premières lignes filaires (UL1, UL2) pour connecter lesdites électrodes unitaires (U1 à Un) desdits groupes d'électrodes (CG1 à CGn) à des lignes correspondantes desdites premières lignes conductrices (L1, L2) respectivement ; et
une pluralité de secondes lignes filaires (OL) pour connecter ladite électrode commune (OE) à ladite seconde ligne conductrice (L3) à des positions correspondant auxdites électrodes unitaires (U1 à Un) ;
de telle manière qu'un ou plusieurs éléments capacitifs (CD) sont ainsi formés et que lesdites premières (UL1, UL2) et secondes (OL) lignes filaires s'étendent dans des directions opposées vers lesdites premières (L1, L2) et seconde (L3) lignes conductrices respectivement.

2. Structure d'arrangement d'éléments capacitifs d'un dispositif semi-conducteur selon la revendication 1, dans laquelle lesdites premières (L1, L2) et seconde (L3) lignes conductrices s'étendent dans une direction sensiblement perpendiculaire auxdits groupes d'électrodes parallèles (CG1 à CGn).

3. Structure d'arrangement d'éléments capacitifs d'un dispositif semi-conducteur selon la revendication 1 ou 2, dans laquelle lesdites premières (UL1, UL2) et secondes (OL) lignes filaires sont sensiblement perpendiculaires auxdites lignes conductrices (L1, L2, L3).
